# DEMANDE DE BREVET EUROPEEN

(11) **EP 0 929 137 A1**
(43) Date de publication de la demande: **14.07.1999**
(21) Numéro de dépôt: 99400006.5
(22) Date de dépôt: 05.01.1999
(51) Int. Cl.: H02B 13/065, G01H 3/08, G01H 3/12

(54) **Ligne à isolation gazeuse à détection et localisation d'arc interne par oscillation en demi-onde du gaz diélectrique dans l'enveloppe**

(30) Priorité: 06.01.1998 FR 9800037
(71) Demandeur: GEC ALSTHOM T & D SA, 75116 Paris (FR)
(72) Inventeur: Moncorge, Jean-Paul, 69120 Vaulx en Velin (FR); Lucot, Lionel, 69210 Fleurieux L'Arbresle (FR)
(74) Mandataire: Gosse, Michel

(57) **Abrégé**

La ligne à isolation gazeuse comprend un conducteur électrique (1) disposé à l'intérieur d'une enveloppe métallique (3) cylindrique de longueur (L) donnée et remplie d'un gaz diélectrique (7) sous pression. La ligne est équipée d'un capteur (11) et d'une unité d'acquisition et de traitement (15), le capteur communiquant avec le gaz diélectrique et délivrant vers l'unité d'acquisition et de traitement un signal (17) pour détecter et localiser un arc interne entre le conducteur électrique et l'enveloppe métallique.

L'unité d'acquisition et de traitement (15) comprend des moyens pour extraire une amplitude (S) du signal (17) à une fréquence de résonance du gaz diélectrique déterminée par la longueur (L) de l'enveloppe métallique (3) cylindrique, ce qui permet d'utiliser un capteur unique et de le placer en un point quelconque de l'enveloppe pour détecter l'oscillation stationnaire du gaz diélectrique dans l'enveloppe consécutive à l'apparition de l'arc interne.

## Description

L'invention se rapporte à une ligne à isolation gazeuse comprenant un conducteur électrique disposé à l'intérieur d'une enveloppe métallique cylindrique de longueur donnée et remplie d'un gaz diélectrique sous pression, la ligne étant équipée d'un capteur et d'une unité d'acquisition et de traitement, le capteur communiquant avec le gaz diélectrique et délivrant vers l'unité d'acquisition et de traitement un signal pour détecter et localiser un arc interne entre le conducteur électrique et l'enveloppe métallique.

Une telle ligne est connue notamment du document intitulé "Application of gas pressure sensor for fault location system in gas insulated substation", publié par IEEE Transaction on Power Delivery, 10(4), pp. 1806-1815, Oct. 1995. Le montage expérimental décrit dans ce document se rapporte à une ligne d'une longueur de 7 mètres (m). Le capteur utilisé est un capteur de pression du type piézo-électrique. Il est monté au milieu de la ligne ou à une extrémité. Une augmentation de la pression du gaz diélectrique contenu dans l'enveloppe métallique, consécutive à l'apparition d'un arc interne, est détectée et localisée par le capteur de pression. La méthode de mesure repose sur la propagation dans l'enveloppe métallique d'un front d'onde de pression depuis l'arc interne vers le capteur de pression.

Le problème qui est résolu par l'invention se pose par rapport à une ligne de grande longueur, de l'ordre de 100 m, qui correspond à un standard d'utilisation. Il n'existe que peu d'espoir de mesurer le front d'onde de pression avec seulement un capteur de pression placé au milieu ou à une extrémité de la ligne, compte tenu de l'amortissement de ce front d'onde au cours de sa propagation. La solution qui consisterait à placer plusieurs capteurs de pression à intervalles réguliers le long de la ligne apparaît immédiatement trop coûteuse.

Le but de l'invention est de détecter et localiser un arc interne dans une ligne à isolation gazeuse de grande longueur.

A cet effet, l'invention a pour objet une ligne à isolation gazeuse comprenant un conducteur électrique disposé à l'intérieur d'une enveloppe métallique cylindrique de longueur donnée et remplie d'un gaz diélectrique sous pression, la ligne étant équipée d'un capteur et d'une unité d'acquisition et de traitement, le capteur communiquant avec le gaz diélectrique et délivrant vers l'unité d'acquisition et de traitement un signal pour détecter et localiser un arc interne entre le conducteur électrique et l'enveloppe métallique, caractérisée en ce l'unité d'acquisition et de traitement comprend des moyens pour extraire une amplitude du signal à une fréquence de résonance du gaz diélectrique déterminée par la longueur de l'enveloppe métallique cylindrique.

L'arc interne donne naissance à une oscillation stationnaire du gaz diélectrique en demi-onde dont la fréquence de résonance est déterminée par la longueur de l'enveloppe métallique. Cette oscillation s'amortit dans le temps, mais possède des amplitudes fixes par rapport à la longueur de l'enveloppe, avec une amplitude de pression maximale aux deux extrémités, et une amplitude de vitesse vibratoire maximale au milieu de l'enveloppe.

Selon l'invention, les moyens par lesquels l'unité d'acquisition et de traitement extrait l'amplitude du signal délivré par le capteur à la fréquence de résonance, permettent d'utiliser un capteur unique et de le placer en un point quelconque de l'enveloppe pour détecter l'oscillation stationnaire du gaz diélectrique dans l'enveloppe consécutive à l'apparition de l'arc interne.

Avantageusement, on utilise un capteur de pression disposé à une extrémité de l'enveloppe métallique pour tirer profit d'une amplitude maximale de la pression de l'oscillation stationnaire en ce lieu. De même, on utilise un capteur de vitesse vibratoire disposé au milieu de l'enveloppe métallique pour tirer profit d'une amplitude maximale de la vitesse vibratoire de l'oscillation stationnaire en ce lieu.

D'autres caractéristiques et avantages de l'invention apparaîtront à la lecture de la description de deux modes de réalisation de l'invention illustrés par les dessins.

La figure 1 montre schématiquement une ligne à isolation gazeuse équipée d'un capteur de pression et d'une unité d'acquisition et de traitement.

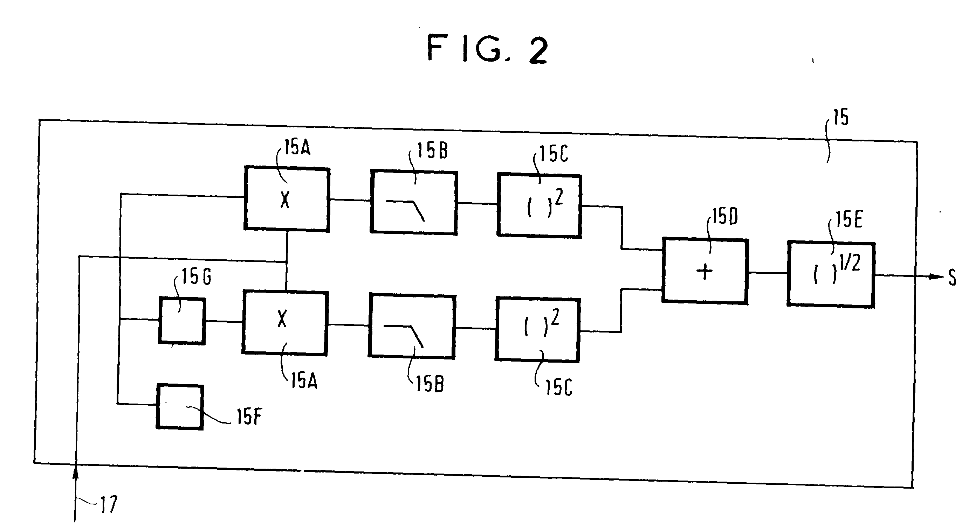

La figure 2 montre schématiquement une unité d'acquisition de et traitement à deux chaînes de mesure.

La figure 3 montre schématiquement une ligne à isolation gazeuse équipée d'un capteur de pression différentiel et d'une unité d'acquisition et de traitement.

La figure 4 montre une ligne à isolation gazeuse équipée d'un capteur de vitesse vibratoire et d'une unité d'acquisition et de traitement.

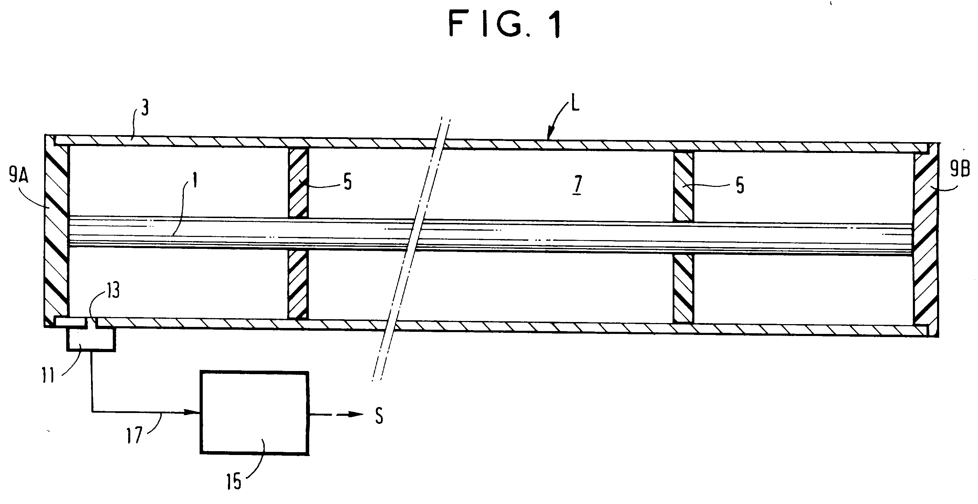

Sur la figure 1, on a représenté en vue de coupe transversale une ligne à isolation gazeuse qui comprend un conducteur électrique 1 en aluminium maintenu à l'intérieur d'une enveloppe cylindrique en acier 3 par des supports isolants en résine époxyde 5. Il est prévu de disposer deux autres conducteurs électriques dans la cas où la ligne doit transporter un courant électrique triphasé. Le diamètre extérieur de l'enveloppe métallique 3 est égal à 1,22 m et son épaisseur, à 0,01 m.

Un gaz diélectrique 7 est présent dans l'enveloppe sous une pression de quelques bars. Le gaz diélectrique est l'azote N₂ sous une pression de 10 bars, mais il est également prévu d'utiliser de l'hexafluorure de soufre SF₆ sous la même pression. L'enveloppe métallique est fermée aux deux extrémités par des bords isolants 9A et 9B en délimitant une section de ligne dont la longueur L est égale à 100 m.

Lors de l'apparition d'un arc interne entre le conducteur électrique 1 et l'enveloppe métallique 3, ou entre les conducteurs d'une ligne à courant triphasé, une augmentation brusque de la pression donne naissance, par résonance, à une oscillation stationnaire du gaz diélectrique 7 en demi-onde dont la fréquence de résonance est déterminée par la longueur L de l'enveloppe métallique. La vitesse de propagation de l'onde dans l'azote étant de 340 mètres par seconde, à la température ambiante, la fréquence de résonance déterminée par la longueur de l'enveloppe métallique 3 est égale à 1,7 hertz (Hz).

La ligne à isolation gazeuse est équipée d'un capteur 11 qui délivre un signal 17 représentatif de la valeur instantanée de l'amplitude de l'oscillation stationnaire du gaz diélectrique contenu dans l'enveloppe, vers une unité d'acquisition et de traitement 15.

Selon l'invention, l'unité de traitement et d'acquisition 15 comprend un moyen du type d'un analyseur de signal à transformées de Fourrier pour extraire l'amplitude du signal à la fréquence de résonance de l'oscillation en demi-onde du gaz diélectrique 7, soit 1,7 Hz. L'analyseur effectue au préalable un échantillonnage discret du signal à une fréquence d'échantillonnage suffisamment élevée par rapport 1,7 Hz, soit par exemple à 100 Hz.

Selon une variante de réalisation de l'invention, l'unité d'acquisition et traitement 15 comprend deux chaînes de mesure identiques montées en parallèle. Chaque chaîne comprend un multiplicateur 15 A en série avec un filtre passe-bas 15B et un élévateur au carré 15C. Les sorties des deux élévateurs sont réunies à l'entrée d'un circuit de sommation 15D qui est connecté en série avec un extracteur de racine carrée 15E. Le signal 17 délivré par le capteur 11 est appliqué simultanément aux deux multiplicateurs. Un générateur 15F fournit en permanence sur l'un 15A des deux multiplicateurs, un premier signal sinusoïdal de fréquence égale à la fréquence de résonance de l'oscillation stationnaire, et sur l'autre multiplicateur 15B, un deuxième signal de même fréquence et déphasé de 90 degrés par rapport au premier par l'intermédiaire d'un déphaseur 15G. Les deux chaînes calculent en permanence deux composantes orthogonales de la fréquence de résonance de l'oscillation stationnaire. La sommation puis l'extraction de la racine carrée permettent de calculer la valeur S de l'amplitude d'une combinaison du signal 17 délivré par le capteur 11 et combiné avec le signal fournit par le générateur 15F. Si cette amplitude S dépasse un certain seuil, elle est enregistrée par l'unité d'acquisition et de traitement 15 pour garder en mémoire l'instant de détection de l'oscillation stationnaire et aider à la localisation dans l'enveloppe métallique d'un arc interne responsable de cette oscillation.

Dans le mode de réalisation de l'invention représenté figure 1, le capteur 11 est un capteur de pression du type piézo-électrique. Il est fixé sur la paroi extérieure de l'enveloppe métallique 3 en étant vissé dans conduit fileté 13 par lequel il communique avec le gaz diélectrique. De préférence, le capteur de pression 11 est placé à une extrémité de la section pour tirer profit d'une amplitude maximale de la pression de l'oscillation en demi-onde du gaz diélectrique contenu dans l'enveloppe métallique.

D'une manière connue en pratique, l'augmentation brusque de pression consécutive à l'apparition d'un arc interne est de l'ordre de 0,1 bar de la pression de repos du gaz diélectrique contenu dans l'enveloppe, soit une proportion relative de 1% comparativement à une pression de repos de 10 bars.

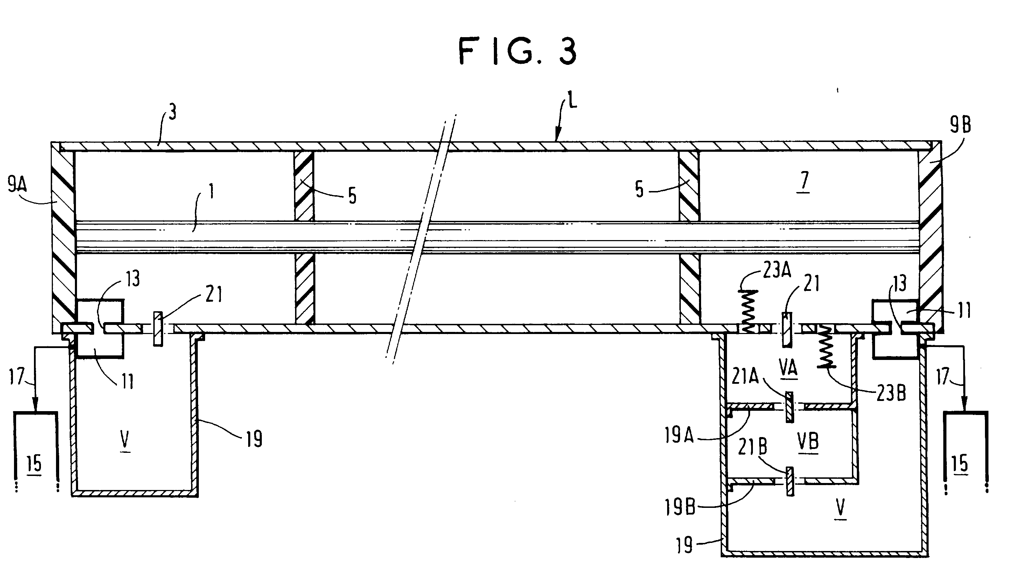

Avantageusement, l'invention prévoit d'utiliser un capteur de pression différentiel communiquant d'une part avec le volume intérieur de l'enveloppe métallique et d'autre part avec un volume de référence. Sur la figure 3 à gauche, un réservoir 19 est monté sur la paroi extérieure et à une extrémité de l'enveloppe métallique 3. Le volume intérieur de ce réservoir, dit volume de référence V est mis en communication avec le volume intérieur de l'enveloppe métallique 3 par un évent 21 pour assurer un équilibre de la pression de repos du gaz diélectrique dans l'enveloppe métallique 3 et dans le réservoir 19. Le capteur de pression 11 est du type d'un capteur différentiel et est monté à l'interface entre l'enveloppe métallique et le réservoir pour être en communication avec d'une part le gaz diélectrique contenu dans le volume de l'enveloppe métallique 3 et d'autre part le gaz diélectrique contenu dans le volume de référence V du réservoir 19.

Le volume de référence V et l'évent 21 sont choisis pour que le temps nécessaire à l'équilibre de la pression entre l'enveloppe et le réservoir soit environ 10 fois supérieur à la période de l'oscillation stationnaire égale à 0,58 seconde (s). A titre d'exemple, le volume de référence V et l'évent 21 ont une constante de 10 s pour que le capteur de pression différentiel détecte 90% de l'amplitude de l'oscillation stationnaire.

D'une manière avantageuse, il est prévu de disposer en série plusieurs réservoirs ayant des volumes de référence VA, VB et V, visibles à droite sur la figure 3. Le montage en série signifie que le qu'un premier réservoir 19A est monté à l'interface avec l'enveloppe métallique 3, le volume de référence VA correspondant communiquant avec le volume intérieur de l'enveloppe métallique 3 par un premier évent 21A; qu'un deuxième réservoir 19B est monté à l'interface avec le premier réservoir 19A, le volume correspondant VB communiquant avec le volume de référence précédent VA par un deuxième évent 21B; qu'un troisième réservoir 19 est monté à l'interface d'une part, avec le deuxième réservoir 19B, le volume de référence V correspondant communiquant avec le volume précédent VB par un troisième évent 21, et d'autre part, avec l'enveloppe métallique 3, le capteur de pression différentiel 11 étant monté de part et d'autre de cette interface pour communiquer avec le volume intérieur de l'enveloppe métallique 3 et avec le volume de référence V. Les réservoirs sont montés en série pour que le temps nécessaire pour que la pression s'équilibre entre le volume intérieur de l'enveloppe métallique 3 et le volume de référence V résulte de l'addition des temps nécessaires à l'équilibre entre l'enveloppe métallique et le premier réservoir, entre le premier et le deuxième réservoirs, et entre le deuxième et le troisième réservoirs. Cet agencement de plusieurs réservoirs en série permet d'obtenir un filtrage suffisant de l'oscillation stationnaire dans le volume de référence V, même si le volume disponible pour l'ensemble des trois réservoirs est limité.

Il est également prévu, figure 3 à droite, de disposer des soupapes de sécurité 23A et 23B de part et d'autre de l'interface sur laquelle est montée le capteur de pression différentiel 11 pour rétablir un équilibre de la pression entre l'enveloppe métallique 3 et le réservoir de volume de référence V. Ces soupapes de sécurité 23A et 23B permettent ainsi de protéger le capteur de pression différentiel 11 d'écarts de pression importants qui surviennent par exemple lors de mise sous pression de l'enveloppe métallique 3, ou d'une mise à la pression atmosphérique.

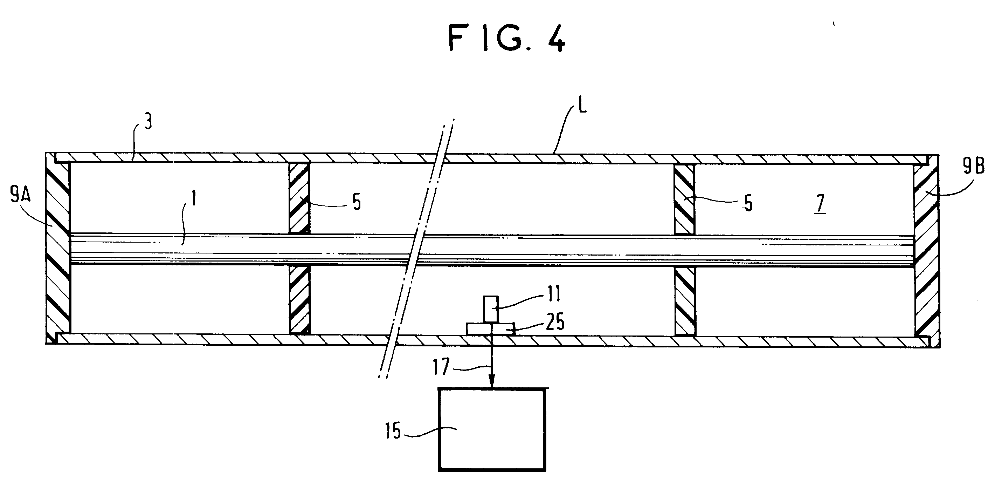

Selon un deuxième de réalisation de l'invention, figure 4, le capteur 11 est un capteur de vitesse vibratoire monté à l'intérieur de l'enveloppe métallique 3 par l'intermédiaire d'une embase 25. Il est disposé de préférence au milieu de l'enveloppe métallique 3 pour tirer profit d'une amplitude maximale de la vitesse vibratoire de l'oscillation stationnaire en ce lieu.

Il est prévu de combiner un capteur de pression et un capteur de vitesse vibratoire dans une même section de ligne à isolation gazeuse selon l'invention.

## Revendications

1. Une ligne à isolation gazeuse comprenant un conducteur électrique (1) disposé à l'intérieur d'une enveloppe métallique (3) cylindrique de longueur (L) donnée et remplie d'un gaz diélectrique (7) sous pression, la ligne étant équipée d'un capteur (11) et d'une unité d'acquisition et de traitement (15), le capteur communiquant avec le gaz diélectrique et délivrant vers l'unité d'acquisition et de traitement un signal (17) pour détecter et localiser un arc interne entre le conducteur électrique et l'enveloppe métallique, caractérisée en ce l'unité d'acquisition et de traitement (15) comprend des moyens pour extraire une amplitude (S) du signal (17) à une fréquence de résonance du gaz diélectrique déterminée par la longueur (L) de l'enveloppe métallique (3) cylindrique.

2. Une ligne à isolation gazeuse selon la revendication 1, dans laquelle l'unité d'acquisition et de traitement (15) comprend un analyseur de signal à transformées de Fourrier.

3. Une ligne à isolation gazeuse selon la revendication 1, dans laquelle l'unité d'acquisition et de traitement (15) comprend deux chaînes de mesure identiques montées en parallèle ayant chacune un multiplicateur (15A) en série avec un filtre passe-bas (15B) et un élévateur au carré (15C), les deux élévateurs (15C) étant connectés à un extracteur de racine carrée (15E) par l'intermédiaire d'un circuit de sommation (15D), un générateur (15F) fournissant en permanence sur l'un (15A) des deux multiplicateurs, un premier signal sinusoïdal à la fréquence de résonance, et sur l'autre multiplicateur (15B), un deuxième signal de même fréquence et déphasé de 90 degrés par rapport au premier par l'intermédiaire d'un déphaseur (15G).

4. Une ligne à isolation gazeuse selon la revendication 2 ou 3, dans laquelle le capteur (11) est un capteur de pression disposé à une extrémité de l'enveloppe métallique (3).

5. Une ligne à isolation gazeuse selon la revendication 4, dans laquelle le capteur de pression (11) est un capteur de pression différentiel monté à l'interface entre l'enveloppe métallique (3) et un premier réservoir (19) délimitant un volume de référence (V) ouvert sur l'enveloppe métallique (3) par un évent (21).

6. Une ligne à isolation gazeuse selon la revendication 5, dans laquelle le volume de référence (V) délimité par le premier réservoir (19) est ouvert sur l'enveloppe métallique (3) par l'intermédiaire de volumes de référence (VA,VB) délimités par des réservoirs (19A,19B) disposés en série avec le premier réservoir (19) et qui communiquent entre eux par des évents (21A,21B), l'un de ces réservoirs (19A) communiquant avec l'enveloppe métallique (3) par un évent (21).

7. Une ligne à isolation gazeuse selon la revendication 5 ou 6, dans laquelle des soupapes (23A,23B) sont montées de part et d'autre de l'interface entre l'enveloppe métallique (3) et le premier réservoir (19).

8. Une ligne à isolation gazeuse selon la revendication 2 ou 3, dans laquelle la capteur (11) est un capteur de vitesse vibratoire disposé au milieu de la longueur de l'enveloppe métallique (3).
